# EUROPÄISCHE PATENTANMELDUNG

(11) **EP 0 800 102 A1**
(43) Veröffentlichungstag der Anmeldung: **08.10.1997**
(21) Anmeldenummer: 97105147.9
(22) Anmeldetag: 26.03.1997
(51) Int. Cl.: G02B 6/42

(54) **Modul mit befestigter Komponente und Verfahren zum Befestigen der Komponente**

(30) Priorität: 02.04.1996 DE 19613236
(71) Anmelder: Coherent-ADLAS GmbH & Co. KG, 23569 Lübeck (FR)
(72) Erfinder: Seelert, Wolf, Dr., 23560 Lübeck (DE); Lawrenz-Stolz, Jörg, Dr., 23701 Süsel-Zarnekau (DE); Wilhelm, Herry, 23552 Lübeck (DE); Stamer, Kai-Peter, 23552 Lübeck (DE)
(74) Vertreter: Klunker . Schmitt-Nilson . Hirsch

(57) **Zusammenfassung**

Die Erfindung betrifft ein Modul mit einer oder mehrerer mittels eines Befestigungsmittels 14 auf einem Substrat 4 befestigten Komponenten 2, 15 und mindestens einer zur Erwärmung des Befestigungsmittels 14 während der Befestigung vorgesehenen Heizeinrichtung 7 sowie ein Verfahren zum Befestigen einer oder mehrerer Komponenten 2, 15 auf einem Substrat 4, wobei ein Befestigungsmittel 14 durch mindestens eine Heizeinrichtung 7 während der Befestigung erwärmt wird.

Ein solches Verfahren und ein Modul sollen dahingehend verbessert werden, daß die Komponente während der Befestigung nicht wesentlich über die zum Befestigen nötige Temperatur hinaus aufgeheizt werden muß.

Die Verbesserung wird dadurch erzielt, daß die Heizeinrichtung als Thermistor, z.B. als Kaltleiter 7 ausgebildet ist, der während des Befestigungsvorgangs mit Spannung versorgt wird.

## Beschreibung

Die Erfindung betrifft ein Modul mit einer mittels eines Befestigungsmittels auf einem Substrat befestigten Komponente und einer zur Erwärmung des Befestigungsmittels während der Befestigung vorgesehenen Heizeinrichtung, sowie ein Verfahren zum Befestigen einer Komponente auf einem Substrat, wobei ein Befestigungsmittel während der Befestigung erwärmt wird.

Ein Modul und ein Verfahren der genannten Art sind aus der EP 0 196 875 bekannt geworden. Bei dem bekannten Verfahren wird eine optische Komponente in Form einer optischen Faser auf einem Substrat aufgelötet, wobei das Lot durch eine fortwährend an der Komponente befestigte Heizeinrichtung geschmolzen wird. Die Heizeinrichtung ist in Form eines Chipwiderstandes ausgebildet. Nachteilig an dem bekannten Verfahren ist, daß die Temperatur, auf die die Lötstelle durch die Heizeinrichtung erwärmt wird, schwer zu kontrollieren ist und über der Fläche der Heizeinrichtung erheblich variieren kann. Um auch bei einer Massenproduktion sicher löten zu können, muß die Lötstelle weit über die Schmelztemperatur des Lotes erwärmt werden. Dadurch kann die zu befestigende Komponente geschädigt werden, und es kommt beim Abkühlen zu starken Spannungen in der Lötstelle.

Aufgabe der Erfindung ist es, ein Verfahren und ein Modul anzugeben, bei dem die geschilderten Nachteile vermieden werden.

Die Aufgabe wird dadurch gelöst, daß die Heizeinrichtung als Thermistor ausgebildet ist, der während des Befestigungsvorgangs mit Spannung bzw. mit Strom versorgt wird.

Der Vorteil der Erfindung liegt darin, daß ein mit einer bestimmten Spannung versorgter Kaltleiter (PTC-Widerstand) und auch ein Heißleiter (NTC-Widerstand), in den ein bestimmter, konstanter Strom eingespeist wird, beim Erwärmen des Befestigungsmittels eine in engen Grenzen definierte Temperatur annimmt, ohne daß eine Temperaturmessung und -regelung nötig wäre. Auch ist die Temperaturverteilung über der Fläche des Thermistors sehr gleichmäßig. Dadurch ist es nicht wie bei dem bekannten Verfahren notwendig, das Befestigungsmittel weit über die eigentlich nötige Temperatur hinaus zu erwärmen. Somit wird die zu befestigende Komponente geschont, und es kommt nur zu geringen mechanischen Spannungen und kaum zu einer Dejustage der Komponente beim Abkühlen des Befestigungsmittels.

Zur Darstellung der Erfindung wird im folgenden speziell auf einen mit konstanter Spannung betriebenen Kaltleiter (PTC-Widerstand) Bezug genommen; entsprechende Verhältnisse gelten aber auch für einen Heißleiter (NTC-Widerstand (Kaltleiter und Heißleiter sind beide "Thermistoren). Bei einem Heißleiter wird nicht die Spannung sondern der Strom konstant gehalten).

In der Kennlinie eines Kaltleiters, in der sein Widerstand über seiner Temperatur aufgetragen ist, gibt es einen schmalen Temperaturbereich, in dem der Widerstand sehr stark mit der Temperatur ansteigt. Die Temperatur an der unteren Grenze dieses Bereichs wird als Bezugstemperautr bezeichnet. Wird der frei in der Luft befindliche Kaltleiter mit seiner in den Datenblättern angegebenen Nennspannung versorgt, so nimmt er eine Temperatur an, die etwa in der Mitte des steilen Teils seiner Kennlinie liegt. Diese Temperatur wird im folgenden als Nenntemperatur bezeichnet. Wird dem Kaltleiter mehr (oder weniger) Wärme entzogen, so nimmt er eine geringfügig niedrigere (bzw. höhere) Temperatur an, und der Strom durch den Kaltleiter steigt (bzw. sinkt) bei konstant gehaltener Versorgungsspannung. Solange der Kaltleiter im steilen Teil seiner Kennlinie (in dem der Widerstand sehr stark mit der Temperatur ansteigt) betrieben wird, ändert sich über einen weiten Bereich der Versorgungsspannung und der abgeführten Wärmemenge seine Temperatur nur gering (z.B. ± 5°C bis ± 20°C je nach Kaltleitertyp). Die geringe Abhängigkeit der Temperatur von der Versorgungsspannung kann ausgenutzt werden, um die Temperatur des Kaltleiters durch die Wahl einer bestimmten Versorgungsspannung genau an die Erfordernisse während des Befestigungsvorgangs anzupassen.

Das verwendete Befestigungsmittel kann ein Lot sein. Als Kaltleiter wird dann ein Typ eingesetzt, dessen Nenntemperatur einige Grad oberhalb der Schmelztemperatur des Lotes liegt. Dadurch ist ein zuverlässiges Schmelzen des Lotes möglich, ohne daß die Komponente unnötig weit aufgeheizt werden muß.

Als Befestigungsmittel kann auch ein Kleber (z.B. ein Ein- oder Zweikomponenten-Epoxidharz) dienen. Diese Kleber härten bei einer bestimmten Temperatur optimal aus. Es wird in diesem Fall ein Kaltleiter mit einer Nenntemperatur nahe (z.B. ± 20°C) der optimalen Aushärtetemperatur des Klebers gewählt.

Als Befestigungsmittel kann auch ein thermoplastischer Kunststoff (z.B. in Form eines zwischen Substrat und Komponente gelegten dünnen Plättchens) verwendet werden. Es wird dann ein Kaltleiter mit einer einige Grad über der Schmelztemperatur des Kunststoffs liegenden Nenntemperatur gewählt. Beim Befestigungsvorgang wird der Kunststoff geschmolzen und verliebt beim Erkalten das Substrat und die Komponente miteinander.

Für die Anordnung des Kaltleiters und der Komponente auf dem Substrat gibt es verschiedene Möglichkeiten:

Der Kaltleiter kann direkt oder mittels Zwischenschichten auf dem Substrat fixiert sein, z.B. durch Löten (mit Hart- oder Weichlot), mittels thermoplastischem Kunststoff, durch Kleben, durch Schrauben oder Klemmen. Die Komponente wird dann auf der dem Substrat abgewandten Seite des Kaltleiters befestigt.

Der Kaltleiter kann auch auf der Unterseite des Substrats fixiert werden, und die Komponente wird auf der Oberseite des Substrats befestigt. Die zum Befestigen erforderliche Wärme wird dann durch das Substrat hindurchgeleitet.

Weiter ist es möglich, die Komponente mit dem Befestigungsmittel direkt oder mit Zwischenschichten (z.B. zur Verbesserung der Lötbarkeit) auf dem Substrat zu befestigen, wobei der Kaltleiter auf der dem Substrat abgewandten Oberfläche der Komponente fixiert ist. Die zum Befestigen erforderliche Wärme wird dann durch die Komponente hindurchgeleitet.

Statt den Kaltleiter auf der Komponente zu fixieren, ist es auch möglich, den Kaltleiter auf dem Substrat neben der Komponente zu fixieren. Es können auch mehrere Kaltleiter um eine Komponente herum angeordnet werden, oder es kann ein Kaltleiter mit einer Öffnung, in der die Komponente angeordnet wird, eingesetzt werden. Die zum Befestigen erforderliche Wärme wird dann seitlich durch das Substrat geleitet.

Die Fixierung des Kaltleiters auf dem Substrat kann vor der Befestigung der Komponente vorgenommen werden, wobei z.B. bei einer Fixierung durch Löten ein Lot verwandt wird, das einen höheren Schmelzpunkt hat als das zur Befestigung der Komponente vorgesehene Lot. Damit wird sichergestellt, daß sich der Kaltleiter während der Befestigung der Komponente nicht löst.

Andererseits ist es möglich, den Kaltleiter und die Komponente in einem Arbeitsgang auf dem Substrat durch Löten, Kleben oder mittels thermoplastischem Kunststoff zu befestigen. Die zum Befestigen erforderliche Wärme für beide Befestigungsstellen (z.B. Kaltleiter auf Substrat und Komponente auf Kaltleiter) wird dann von dem Kaltleiter aufgebracht.

Auf alle beschriebenen Weisen können auch mehrere Komponenten gleichzeitig mit einem Kaltleiter befestigt werden, oder es können zur Befestigung einer Komponente mehrere Kaltleiter eingesetzt werden (z.B. bei sehr großen Komponenten).

Die Spannungsversorgung des Kaltleiters kann über dauerhaft befestigte Drähte bzw. Leiterbahnen erfolgen, oder es kann eine vorübergehende Verbindung z.B. mittels aufgesetzter Kontaktspitzen oder Klemmen hergestellt werden.

Die dazu befestigenden Komponenten können z.B. mechanische, elektrische, elektronische oder optische Bauteile sein. Beispiele für optische Bauteile sind: Spiegel, Linsen, optische Fasern, Blenden, Prismen, Polarisatoren, Laserkristalle und optisch nichtlineare Kristalle.

Die Erfindung wird anhand eines Ausführungsbeispiels und der Zeichnung näher erläutert. Es zeigen:
- Fig. 1: eine Teilansicht eines Moduls,
- Fig. 2: eine Anordnung des Kaltleiters unter dem Substrat,
- Fig. 3: eine Anordnung des Kaltleiters auf der Komponente und
- Fig. 4: eine Anordnung von Kaltleitern neben der Komponente und
- Fig. 5: eine Draufsicht auf ein Modul mit mehreren, Seite an Seite angeordneten optischen Fasern.

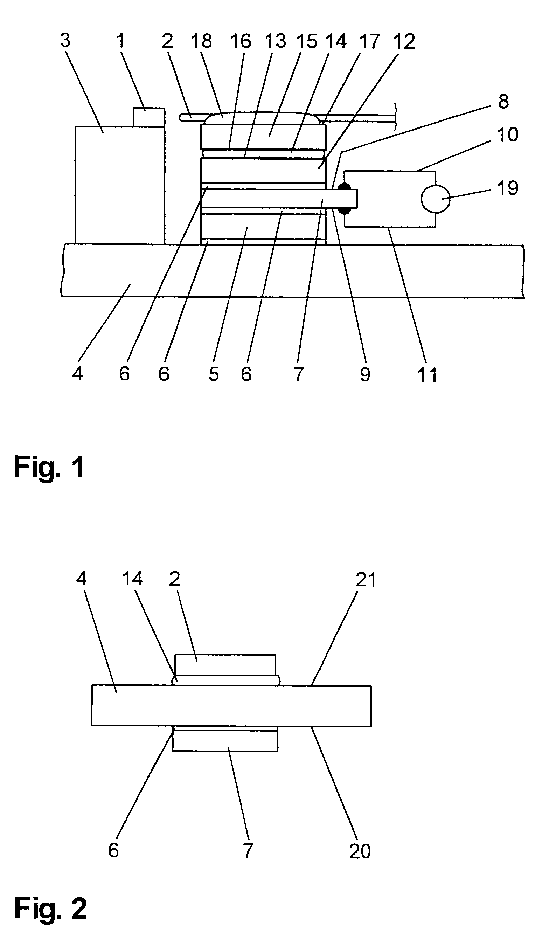

Das in Fig. 1 dargestellte Modul dient zur Koppelung eines Halbleiterlasers 1 an eine optische Faser 2, die (zusammen mit einer Trägerplatte 15) die zu befestigende Komponente darstellt. Der Halbleiterlaser 1 ist auf einem Kühlblock 3 und dieser wiederum auf einem plattenförmigen Substrat 4, das z.B. aus Keramik gefertigt ist, befestigt. Neben dem Kühlblock 3 ist auf dem Substrat 4 zur thermischen Isolierung eine Keramikplatte 5 mittels Klebstoff 6 befestigt. Auf der Keramikplatte 5 ist ein als Kaltleiter 7 ausgebildeter Thermistor aufgeklebt. Er überragt rechts die Keramikplatte 5, so daß an der oberen und unteren Oberfläche 8, 9 elektrische Zuleitungsdrähte 10, 11 angelötet werden konnten. Auf der oberen Oberfläche 8 des Kaltleiters 7 ist eine Trägerplatte 12 aufgesierung 13 ist mittels Lot 14 eine zweite Trägerplatte 15 befestigt. Die dem Lot 14 zugewandte Oberfläche der zweiten Trägerplatte 15 ist mit einer lötbaren Metallisierung 16 versehen. Auf der oberen Oberfläche 17 der zweiten Trägerplatte 15 ist mittels Epoxidkleber 18 die optische Faser 2 fixiert.

Dieser Epoxidkleber 18 hat eine sogenannte Glastemperatur, oberhalb der er weich wird. Würde bei der Befestigung die Glastemperatur überschritten, so könnte sich die Faser 2 auf der zweiten Trägerplatte 15 verschieben oder gar lösen. Die Schmelztemperatur von Sonderweichloten liegt nur etwa 10°C bis 40°C unterhalb der Glastemperatur des Klebers. Daher ist hier der Einsatz des Kaltleiters 7 zur Befestigung der Komponente von großem Nutzen, denn er erlaubt eine exakte Einhaltung einer möglichst niedrigen Löttemperatur.

Vor der Befestigung der optischen Faser 2 werden die Bauteile 1, 3 - 13 einerseits und 2, 15 - 18 andererseits vormontiert. Zur Befestigung der optischen Faser 2 an dem Laser wird der Kaltleiter 7 über die Drähte 10, 11 mit einer Spannungsquelle 19 verbunden. Nach kurzer Aufheizzeit hat er seine Solltemperatur erreicht, und auf die Metallisierung 13 der Trägerplatte 12 wird Lot 14 aufgebracht, welches schmilzt und verläuft. Auf das flüssige Lot 14 wird die zweite Trägerplatte 15 mit der angeklebten optischen Faser 2 aufgelegt. Über eine Messung des von dem Halbleiterlaser 1 in die optische Faser 2 eingekoppelten Lichts wird die optische Faser 2 optimal ausgerichtet. Dann wird die Spannungsquelle 19 von dem Kaltleiter 7 getrennt, wodurch dieser abkühlt und daraufhin das Lot 14 erstarrt.

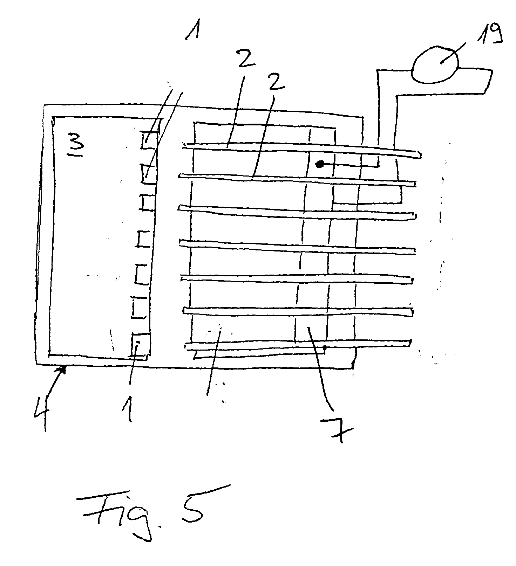

Statt einer einzelnen optischen Faser 2 kann auch ein Faserarray (mehrere nebeneinander angeordnete Fasern), welches dann mit einem Laserdiodenarray gekoppelt wird, auf die beschriebene Weise befestigt werden, wie dies in Fig. 5 gezeigt ist.

Fig. 2 zeigt schematisch die Anordnung von Kaltleiter 7 und Komponente 2 auf einander abgewandten Seiten des Substrats 4. Auf der Unterseite 20 des Substrats 4 ist der Kaltleiter 7 mittels z.B. Kleber 6 fixiert. Die Komponente 2 ist mittels Lot 14 auf der Oberseite 21 des Substrats 4 aufgelötet. Die zum Löten nötige Wärme dringt von dem Kaltleiter 7 durch das Substrat 4 hindurch zu dem Lot 14 vor.

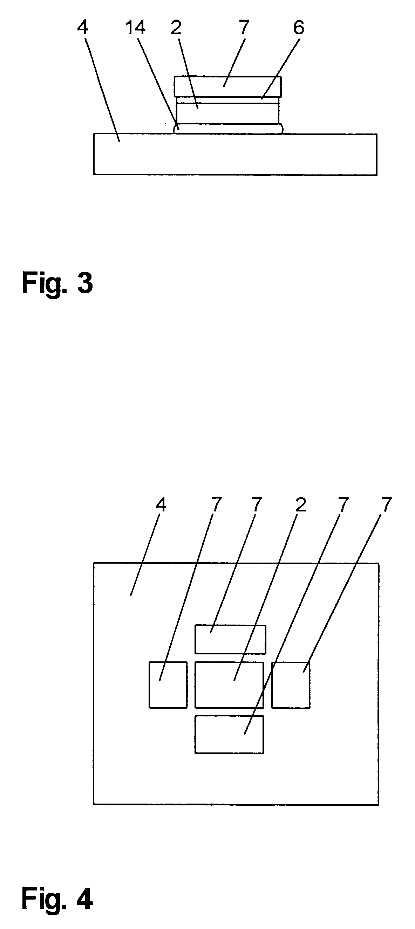

Fig. 3 zeigt eine weitere Anordnung, bei der der Kaltleiter 7 auf der Komponente 2 mittels z.B. Kleber 6 fixiert ist. Die Komponente 2 ist mit der dem Kaltleiter 7 abgewandten Oberfläche über eine Lotschicht 14 auf dem Substrat 4 befestigt. Die zum Löten nötige Wärme gelangt von dem Kaltleiter 7 durch die Komponente 2 hindurch zu der durch das Lot gebildeten Lötstelle.

In Fig. 4 ist ein Substrat 4 in Aufsicht dargestellt, auf dem eine Komponente 2 befestigt ist. Um die Komponente 2 herum sind vier Kaltleiter 7 auf dem Substrat fixiert. Die zum Löten nötige Wärme dringt von den Kaltleitern 7 seitlich durch das Substrat 4 zur Lötstelle vor.

Die oben näher beschriebenen und in der Zeichnung dargestellten Ausführungsbeispiele beziehen sich auf die Kopplung eines Halbleiterlasers mit einer optischen Faser, d.h. die zu befestigende Komponente ist die optische Faser 2 (in Verbindung mit der Trägerplatte 15), und auf dem Substrat befindet sich der Halbleiterlaser. Die Erfindung ist aber gleichermaßen auch noch zur Befestigung anderer Komponenten auf einem Substrat oder einer Unterlage einsetzbar, zum Beispiel kann eine Linse, ein Polarisator oder ein anderes optisches Bauelement unter Zuhilfenahme der erfindungsgemäßen Lehre fixiert werden. Außer optischen Bauelementen und Bauteilen kommen auch noch andere Bauteile in Betracht, beispielsweise können mit Hilfe der erfindungsgemäßen Lehre auch rein mechanische Bauelemente auf einem Substrat (einer Unterlage) fixiert werden.

Für das oben angegebene spezielle Ausführungsbeispiel wurde zur Durchführung des erfindungsgemäßen Verfahrens ein Kaltleiter der Firma SIEMENS vom Typ Q63100-P390-R200 verwendet. Die Nennspannung betrug 24 V; die Nenntemperatur betrug 120°C.

Die Erwärmungszeit, d.h. die Zeit, in der die Spannung von 24 V an die Elektroden des Kaltleiters gelegt ist, betrug 10 Sekunden.

Wie eingangs erwähnt, kann anstelle des Kaltleiters 7 auch ein Heißleiter (NTC-Widerstand) als Thermistor in Verbindung mit einer Stromquelle verwendet werden. Wenn sich der Heißleiter erwärmt, nimmt (bei konstantem Strom) sein Widerstand und damit seine Spannung ab, und die dadurch bedingte Leistungsverminderung hat eine Senkung der Temperatur zur Folge.

## Patentansprüche

1. Verfahren zum Befestigen einer Komponente (2, 15-18) auf einem Substrat (4), wobei ein Befestigungsmittel durch eine Heizeinrichtung während der Befestigung erwärmt wird, **dadurch gekennzeichnet**, daß das Erwärmen des Befestigungsmittels (14) mit Hilfe eines Thermistors (7) erfolgt, der während des Befestigungsvorgangs mit Spannung bzw. Strom versorgt wird.

2. Verfahren nach Anspruch 1, **dadurch gekennzeichnet**, daß das Befestigungsmittel ein Lot (14) ist und die Nenntemperatur des Thermistors (7) 1°C bis 40°C oberhalb der Schmelztemperatur des Lotes (14) liegt.

3. Verfahren nach Anspruch 1, **dadurch gekennzeichnet**, daß das Befestigungsmittel ein Kleber (14) ist und die Nenntemperatur des Thermistors (7) etwa der optimalen Aushärtetemperatur des Klebers (14) entspricht.

4. Verfahren nach Anspruch 1, **dadurch gekennzeichnet**, daß das Befestigungsmittel ein thermoplastischer Kunststoff (14) ist und die Nenntemperatur des Thermistors 1°C bis 40°C über der Schmelztemperatur des thermoplastischen Kunststoffs (14) liegt.

5. Verfahren nach einem der Ansprüche 1 bis 4, **dadurch gekennzeichnet**, daß der Thermistor (7) auf dem Substrat (4) fixiert wird und die Komponente (2, 15) mittels des Befestigungsmittels (14) auf dem Thermistor (7) befestigt wird.

6. Verfahren nach einem der Ansprüche 1 bis 4, **dadurch gekennzeichnet**, daß der Thermistor (7) auf der Unterseite (20) des Substrats (4) fixiert wird und die Komponente (2, 15) mittels des Befestigungsmittels (14) auf der Oberseite (21) des Substrats (4) befestigt wird.

7. Verfahren nach einem der Ansprüche 1 bis 4, **dadurch gekennzeichnet,** daß die Komponente (2, 15) mittels des Befestigungsmittels (14) auf dem Substrat (4) befestigt wird und der Thermistor auf oder neben der Komponente (2, 15) angeordnet ist.

8. Verfahren nach einem der Ansprüche 1 bis 7, **dadurch gekennzeichnet**, daß mehrere Komponenten (2, 15) mittels eines Thermistors (7) befestigt werden.

9. Verfahren nach einem der Ansprüche 1 bis 7, **dadurch gekennzeichnet**, daß eine Komponente (2, 15) mittels mehrerer Thermistoren (7) befestigt wird.

10. Verfahren nach einem der Ansprüche 1 bis 9, **dadurch gekennzeichnet**, daß die Komponente ein optisches Bauteil (2) ist.

11. Modul mit einer mittels eines Befestigungsmittels auf einem Substrat befestigten Komponente und einer zur Erwärmung des Befestigungsmittels während der Befestigung vorgesehenen Heizeinrichtung, **dadurch gekennzeichnet**, daß die Heizeinrichtung als Thermistor (7) ausgebildet ist.

12. Modul nach Anspruch 11, **dadurch gekennzeichnet**, daß das Befestigungsmittel ein Lot (14) ist und die Nenntemperatur des Thermistors (7) 1°C bis 40°C oberhalb der Schmelztemperatur des Lotes (14) liegt.

13. Modul nach Anspruch 11, **dadurch gekennzeichnet**, daß das Befestigungsmittel ein Kleber (14) ist und die Nenntemperatur des Thermistors (7) etwa der optimalen Aushärtetemperatur des Klebers (14) entspricht.

14. Modul nach Anspruch 11, **dadurch gekennzeichnet**, daß das Befestigungsmittel ein thermoplastischer Kunststoff (14) ist und die Nenntemperatur des Thermistors 1°C bis 40°C über der Schmelztemperatur des thermoplastischen Kunststoffs (14) liegt.

15. Modul nach einem der Ansprüche 11 bis 14, **dadurch gekennzeichnet**, daß der Thermistor (7) auf dem Substrat (4) fixiert ist und die Komponente (2, 15) mittels des Befestigungsmittels (14) auf dem Thermistor (7) befestigt ist.

16. Modul nach einem der Ansprüche 11 bis 14, **dadurch gekennzeichnet**, daß der Thermistor (7) auf der Unterseite (20) des Substrats (4) fixiert ist und die Komponente (2, 15) mittels des Befestigungsmittels (14) auf der Oberseite (21) des Substrats (4) befestigt ist.

17. Modul nach einem der Ansprüche 11 bis 14, **dadurch gekennzeich**net, daß die Komponente (2) mittels des Befestigungsmittels (14) auf dem Substrat (4) befestigt ist und der Thermistor (7) auf oder neben der Komponente (2, 15) angeordnet ist.

18. Modul nach einem der Ansprüche 11 bis 17, **dadurch gekennzeich**net, daß ein Thermistor (7) zur Befestigung mehrerer Komponenten (2, 15) vorgesehen ist.

19. Modul nach einem der Ansprüche 11 bis 17, **dadurch gekennzeichnet**, daß mehrere Thermistoren (7) zur Befestigung einer Komponente (2, 15) vorgesehen sind.

20. Modul nach einem der Ansprüche 11 bis 19, **dadurch gekennzeichnet**, daß die Komponente ein optisches Bauteil (2) ist.

21. Modul nach einem der Ansprüche 11 bis 20, **dadurch gekennzeichnet**, daß der Thermistor (7) als Kaltleiter (PTC-Widerstand) ausgebildet ist, an den eine konstante Betriebsspannung gelegt wird.

22. Modul nach einem der Ansprüche 11 bis 20, **dadurch gekennzeichnet**, daß der Thermistor als Heißleiter (NTC-Widerstand) ausgebildet ist, in den ein konstanter Betriebsstrom eingespeist wird.

23. Verfahren nach einem der Ansprüche 1 bis 10, **dadurch gekennzeichnet**, daß der Thermistor (7) als Kaltleiter (PTC-Widerstand) ausgebildet ist, an den eine konstante Betriebsspannung gelegt wird.

24. Verfahren nach einem der Ansprüche 1 bis 10, **dadurch gekennzeichnet**, daß der Thermistor als Heißleiter (NTC-Widerstand) ausgebildet ist, in den ein konstanter Betriebsstrom eingespeist wird.
